# EUROPEAN PATENT APPLICATION

(11) **EP 0 740 304 A2**
(43) Date of publication of application: **30.10.1996**
(21) Application number: 96400882.5
(22) Date of filing: 25.04.1996
(51) Int. Cl.: G11C 11/22

(54) **Ferroelectric memory having a fixed, mid-range potential applied to the plate electrode thereof**

(30) Priority: 25.04.1995 JP 99257/95
(71) Applicant: SONY CORPORATION, Tokyo (JP)
(72) Inventor: Sugiyama, Toshinobu, Shinagawa-ku, Tokyo (JP)
(74) Representative: Thévenet, Jean-Bruno

(57) **Abstract**

A ferroelectric memory, holds a potential of a plate electrode (PL) of a ferroelectric capacitor (FC1) at a fixed potential and then makes a switching transistor conductive (Tr1) in a data write operation. In a data read operation, the ferroelectric memory holds the potential of the plate electrode of the ferroelectric capacitor at a fixed potential and then makes a switching transistor conductive, detects a potential generated in a bit line, latches the bit line (BL1) by the potential, then makes the ferroelectric capacitor (FC1) perform a re-write operation by the potential applied to the two electrodes of the ferroelectric capacitor.

## Description

### Background of the Invention

### 1. Field of the Invention

The present invention relates to a ferroelectric memory for writing and reading data utilizing the direction of polarization of a ferroelectric.

### 2. Description of the Related Art

Two types of ferroelectric nonvolatile memories utilizing the reversal of polarization of a ferroelectric having a hysteresis characteristic have been proposed: a two-transistor two-capacitor (2Tr-2Cap) type wherein one bit is constituted by two switching transistors and two ferroelectric capacitors and a one-transistor one- capacitor (1Tr - 1Cap) type wherein one bit is constituted by one switching transistor and one ferroelectric capacitor.

In the data write and read operations of these types of memories, it is necessary to apply a high-speed pulse to a specific plate line connected to the selected memory cell and, in configuring the memory cell array, it is necessary to form plate lines having a low resistance in parallel with the word lines WL.

In a dynamic random access memory (DRAM) wherein one bit is constituted by one transistor and one capacitor as in the above-mentioned lTr-lCap type ferroelectric memory, the potentials of all the cells connected to a common plate line are usually fixed at the ground GND level or Vcc/2, so it is not necessary to divide the plate line for each word line, the plate electrodes become simple enough in pattern to be able to be laid over the entire memory cell array, and it is not necessary to set the resistance to a lower value.

However, in a ferroelectric memory, since the word lines are divided and due to the limits of patterning precision, it is impossible to decrease the area per memory cell. Also, it is necessary to increase the thickness of the electrodes to realize a low resistance. As a result, step-differences are easily formed and it is difficult to form a high density memory. Accordingly, realization of a ferroelectric memory which can write and read data with a fixed potential of the plate electrodes the same as a DRAM has been desired.

Also, the read operation of a ferroelectric memory is comprised of detection of a re-write of the potential of the bit line followed by another re-write. Note that, it is necessary to raise the plate line from OV to the power supply voltage Vcc while the word line is selected and then lower it from the power supply voltage Vcc to OV.

In usual DRAMs, the re-write is performed along with the data latch operation, so a ferroelectric memory requires double the time of a DRAM.

Accordingly, it has been desired to detect the change of the potential of the bit line and perform a re-write in the time of a single operation.

### SUMMARY OF THE INVENTION

An object of the invention is to provide an improved ferroelectric memory which overcomes these disadvantages of the related art.

According to one aspect of the present invention, there is provided a ferroelectric memory comprising: first and second bit lines; a memory cell comprising a first ferroelectric capacitor having first and second electrodes, a first switching transistor connected between the first bit line and the first electrode of the first ferroelectric capacitor, a second ferroelectric capacitor having first and second electrodes, and a second switching transistor connected between the second bit line and the first electrode of the second ferroelectric capacitor; a first means for making the potentials of the second electrodes of the first and second ferroelectric capacitors a predetermined fixed potential and then making the first and second switching transistors conductive in a data write operation; and a second means for applying a higher potential and a lower potential than a potential of the second electrodes of the first and second ferroelectric capacitors to the first and second bit lines complementarily.

According to a second aspect of the invention, there is provided a ferroelectric memory comprising: first and second bit lines; a memory cell comprising a first ferroelectric capacitor having first and second electrodes, a first switching transistor connected between the first bit line and the first electrode of the first ferroelectric capacitor, a second ferroelectric capacitor having first and second electrodes, and a second switching transistor connected between the second bit line and the first electrode of the second ferroelectric capacitor; a first means for making the first and second switching transistors conductive and then making the potentials of the second electrodes of the first and second ferroelectric capacitors a predetermined fixed potential in a data write operations; and a second means for applying a higher potential and a lower potential than a potential of the second electrodes of the first and second ferroelectric capacitors to the first and second bit lines complementarily.

According to a third aspect of the invention, there is provided a ferroelectric memory, comprising: first and for second bit lines; a memory cell comprising a first ferroelectric capacitor having first and second electrodes, a first switching transistor connected between the first bit line and the first electrode of the first ferroelectric capacitor, a second ferroelectric capacitor having first and second electrodes, and a second switching transistor connected between the second bit line and the first electrode of the second ferroelectric capacitor; a first means for making the potentials of the second electrodes of the first and second ferroelectric capacitors a predetermined fixed potential and then making the first and second switching transistors conductive in a data read operation; and a second means for detecting a difference between a potential of the first bit line and a potential of the second bit line when the switching transistors are made conductive, latching the first and second bit lines by the difference, and making the first and second ferroelectric capacitors perform re-write operations by the potentials applied to the first and second electrodes of the first and second ferroelectric capacitors.

According to the fourth aspect of the invention, there is provided a ferroelectric memory, comprising: first and second bit lines; a memory cell comprising a first ferroelectric capacitor having first and second electrodes, a first switching transistor connected between the first bit line and the first electrode of the first ferroelectric capacitor, a second ferroelectric capacitor having first and second electrodes, and a second switching transistor connected between the second bit line and the first electrode of the second ferroelectric capacitor; a first means for making the first and second switching transistors conductive and then making the potentials of the second electrodes of the first and second ferroelectric capacitors a predetermined fixed potential in a data read operation; and a second means for applying a difference between a potential of the first bit line and a potential of the second bit line when the predetermined fixed potential is applied to the second electrodes of the first and second ferroelectric capacitors, latching the first and second bit lines by the difference, and making the first and second ferroelectric capacitors perform re-write operations by the potentials applied to the first and second electrodes of the first and second ferroelectric capacitors.

According to the fifth aspect of the invention, there is provided a ferroelectric memory, comprising: first and second bit lines; a memory cell comprising a ferroelectric capacitor having first and second electrodes and a switching transistor connected between the first bit line and the first electrode of the ferroelectric capacitor; a first means for making the potential of the second electrode of the ferroelectric capacitor a predetermined fixed potential and then making the switching transistor conductive in a data write operation; and a second means for applying a higher potential and a lower potential than a potential of the second electrode of the ferroelectric capacitor to the first and second bit lines complementarily.

According to the sixth aspect of the invention, there is provided a ferroelectric memory, comprising: first and second bit lines; a memory cell comprising a ferroelectric capacitor having first and second electrodes and a switching transistor connected between the first bit line and the first electrode of the ferroelectric capacitor; a first means for making the switching transistor conductive and then making the potential of the second electrode of the ferroelectric capacitor a predetermined fixed potential in a data write operation; and a second means for applying a higher potential and a lower potential than a potential of the second electrode of the ferroelectric capacitor to the first and second bit lines complementarily.

According to the seventh aspect of the invention, there is provided a ferroelectric memory, comprising: first and second bit lines; a memory cell comprising a ferroelectric capacitor having first and second electrodes and a switching transistor connected between the first bit line and the first electrode of the ferroelectric capacitor; a first means for making the potential of the second electrode of the ferroelectric capacitor a predetermined fixed potential and then making the switching transistor conductive in a data read operation; and a second means for detecting a difference between a potential of the bit line and a separately set reference potential when the switching transistor is made conductive, latching the first and second bit lines by the difference, and making the ferroelectric capacitor perform a re-write operation by the potential applied to the first and second electrodes of the ferroelectric capacitor.

According to the eighth aspect of the invention, there is provided a ferroelectric memory, comprising: first and second bit lines; a memory cell comprising a ferroelectric capacitor having first and second electrodes and a switching transistor connected between the first bit line and the first electrode of the ferroelectric capacitor; a first means for making the switching transistor conductive and then making the potential of the second electrode of the ferroelectric capacitor a predetermined fixed potential in a data read operation; and a second means for detecting a difference between a potential of the bit line and a separately set reference potential when the predetermined fixed potential is applied to the second electrode of the ferroelectric capacitor, latching the first and second bit lines by the difference, and making the ferroelectric capacitor perform a re-write operation by the potential applied to the first and second electrodes of the ferroelectric capacitor.

### BRIEF DESCRIPTION OF THE DRAWINGS

These and other objects and features of the present invention will become more apparent from the following description of the preferred embodiments made with reference to the attached drawings, in which;
Fig. 1 is a view showing the hysteresis of the polarization characteristic of a ferroelectric;
Fig. 2 is an equivalent circuit diagrams showing a basic constitution of a 2Tr - 2Cap type ferroelectric nonvolatile memory;
Fig. 3 is a timing chart showing the timing of a write operation of the ferroelectric nonvolatile memory of Fig. 2;
Fig. 4 is a view showing the polarization states of the ferroelectric nonvolatile memory of Fig. 2 in a write operation;
Fig. 5 is a timing chart showing the timing of a read operation of the ferroelectric nonvolatile memory of Fig. 2;
Fig. 6 is a view showing the polarization states of the ferroelectric nonvolatile memory of Fig. 2 in a read operation;
Fig. 7 is an equivalent circuit diagram of the ferroelectric nonvolatile memory of Fig. 2 as seen from the plate lines;
Fig. 8 is an equivalent circuit diagram showing the basic constitution of a 1Tr - 1Cap type ferroelectric nonvolatile memory;
Fig. 9 is a timing chart showing the timing of operation of the ferroelectric nonvolatile memory of Fig. 8;
Fig. 10 is a view showing the polarization states of the ferroelectric nonvolatile memory of Fig. 8 in a write operation;
Fig. 11 is a timing chart showing the timing of a read operation of the ferroelectric nonvolatile memory of Fig. 8;
Fig. 12 is a view showing the polarization states of the ferroelectric nonvolatile memory of Fig. 8 in a read operation;
Fig. 13 is an equivalent circuit diagram showing a basic constitution of a 2Tr - 2 Cap type ferroelectric nonvolatile memory of a first embodiment of the present invention;
Fig. 14 is a cross-sectional view of principal parts of the ferroelectric nonvolatile memory of Fig. 13;
Fig. 15 is a timing chart showing the timing of a write operation of the ferroelectric nonvolatile memory of Fig. 13;
Fig. 16 is a view showing the polarization states of the ferroelectric nonvolatile memory of Fig. 13 in a write operation;
Fig. 17 is a timing chart showing the timing of a read operation of the ferroelectric nonvolatile memory of Fig. 13;
Fig. 18 is a view showing the polarization states of the ferroelectric nonvolatile memory of Fig. 13 in a read operation;
Fig. 19 is a timing chart showing the timing of another example of a write operation of the ferroelectric nonvolatile memory of Fig. 13;
Fig. 20 is a view showing the polarization states of the ferroelectric nonvolatile memory of Fig. 13 in the write operation of Fig. 19;
Fig. 21 is a timing chart showing the timing of another example of a read operation of the ferroelectric nonvolatile memory of Fig. 13;
Fig. 22 is a view showing the polarization states of the ferroelectric nonvolatile memory of Fig. 13 in the read operation of Fig. 21;
Fig. 23 is an equivalent circuit diagram of a 1Tr - 1 Cap type ferroelectric nonvolatile memory of a second embodiment of the present invention;
Fig. 24 is a timing chart showing the timing of a write operation of the ferroelectric nonvolatile memory of Fig. 23;
Fig. 25 is a view showing the polarization states of the ferroelectric nonvolatile memory of Fig. 23 in a write operation;
Fig. 26 is a timing chart showing the timing of a read operation of the ferroelectric nonvolatile memory of Fig. 23;
Fig. 27 is a view showing the polarization states of the ferroelectric nonvolatile memory of Fig. 23 in a read operation;
Fig. 28 is a timing chart showing the timing of another example of a write operation of the ferroelectric nonvolatile memory of Fig. 23;
Fig. 29 is a view showing the polarization states of the ferroelectric nonvolatile memory of Fig. 23 in the write operation of Fig. 28;
Fig. 30 is a timing chart showing the timing of another example of a read operation of the ferroelectric nonvolatile memory of Fig. 23; and
Fig. 31 is a view showing the polarization states of the ferroelectric nonvolatile memory of Fig. 23 in the read operation of Fig. 30.

### DESCRIPTION OF THE PREFERRED EMBODIMENTS

Before describing the preferred embodiments, the related art will be explained in further detail with reference to the drawings for facilitating the understanding of the invention.

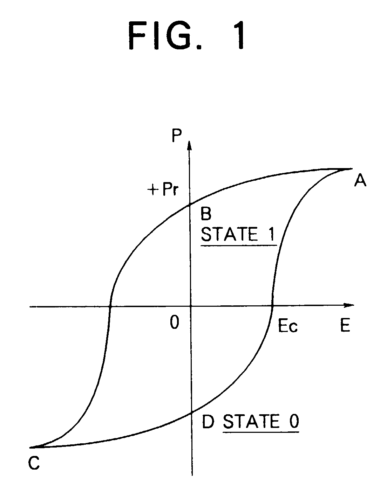

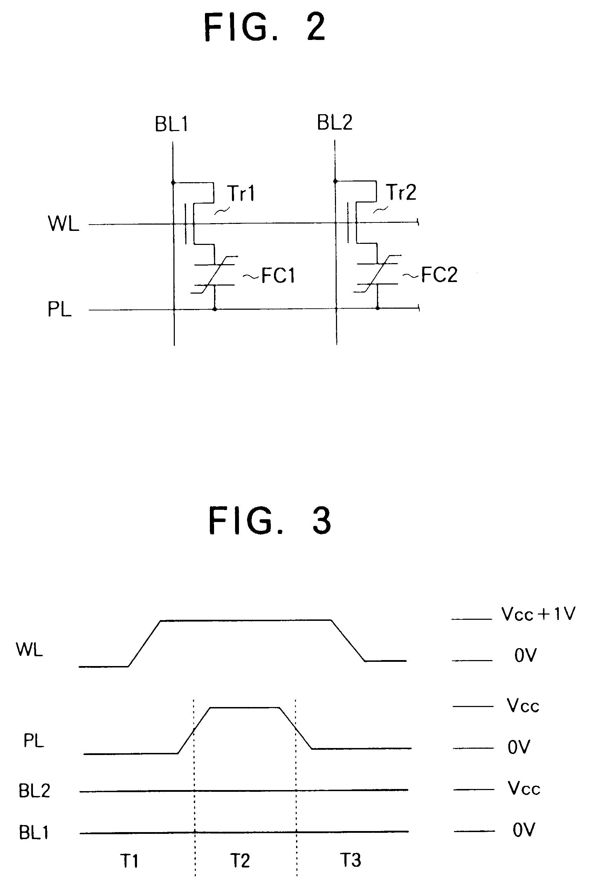

Figure 1 is a view showing the hysteresis of the polarization characteristic of a ferroelectric. Figure 2 is a circuit diagram of a 2Tr - 2Cap type ferroelectric nonvolatile memory cell.

As shown in Fig. 2, the memory cell is comprised of switching transistors Trl, Tr2, comprised of n-channel (N) metal oxide semiconductor (MOS) transistors with drain electrodes connected to a bit line BL1 and a bit line BL2, respectively, and ferroelectric capacitors FC1, FC2, with electrodes connected to source electrodes of the switching transistors Tr1, Tr2, respectively. One bit is constituted by these two pairs of the switching transistors Tr1, Tr2 and the ferroelectric capacitors FC1, FC2. Gate electrodes of the switching transistor Tr1, Tr2 are connected to a common word line WL. The other electrodes (plate electrodes) are connected to a common plate line PL. The bit lines are connected to a not illustrated writing and reading circuit, and the word line WL and the plate line PL are connected to a not illustrated row decoder.

In a 2Tr - 2Cap type memory having the above-mentioned constitution, the ferroelectric films of the two ferroelectric capacitors connected to the bit lines are polarized in reverse directions in a write operation. The polarization states are read in a read operation.

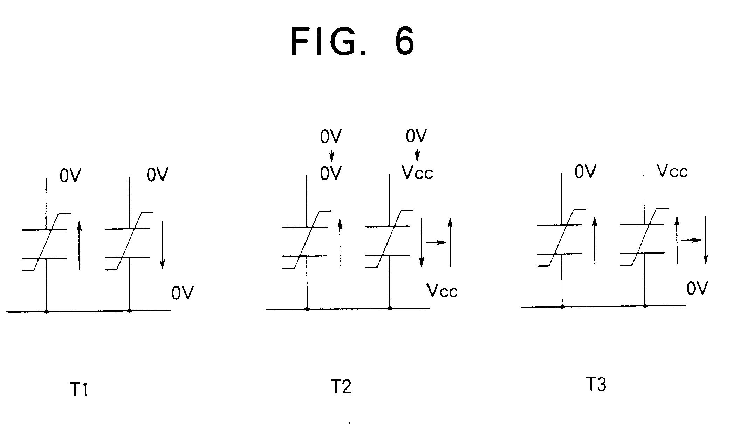

Below, an explanation will be made of the write and read operations of the 2Tr - 2Cap type nonvolatile memory referring to Fig. 3 to Fig. 7.

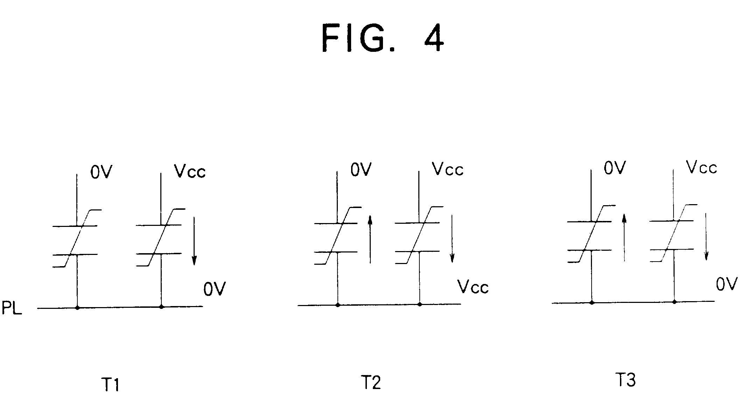

First, an explanation will be made of the write operation by referring to Fig. 3 and Fig. 4.

Figure 3 is a timing chart of potentials applied to the terminals in the write operation, and Fig. 4 shows the states of polarization of a ferroelectric capacitor at that time.

In the write operation, first, in the time T1, a ground GND level OV is applied to the bit line BL1, a power supply voltage Vcc is applied to the bit line BL2, and Vcc + 1V is applied to the word line WL. Note that, the reason for applying a voltage higher than Vcc by 1V is that the threshold voltage Vth of the switching transistor is less than 1V, so it is necessary to prevent a voltage drop due to the transistor.

Due to this, the switching transistors Tr1, Tr2 switch from a non-conductive state to a conductive state, the ground GND level, namely 0V, is applied to a bit line side electrode (one electrode) of the ferroelectric capacitor FC1, and the voltage Vcc is applied to a bit line side electrode of the ferroelectric capacitor FC2. At this time, the plate line PL is held at OV (ground level). As a result, polarization is carried out in a direction from the bit line side electrode to the plate electrode in the ferroelectric capacitor FC2.

Subsequently, the power supply voltage Vcc is applied to the plate line PL in the time T2, and OV is applied to the plate line PL in the time T3. Note that, a pulse wherein the level changes from GND (OV) -> Vcc -> GND (OV) is applied to the plate line PL while the word line WL is held at the power supply voltage Vcc.

Due to this, the direction of polarization of the ferroelectric capacitor FC2 is held from the bit line side electrode to the plate line side electrode. In this state, polarization occurs in the ferroelectric capacitor FC1. The direction of polarization of the capacitor FC1 becomes from the plate line side electrode to the bit line side electrode. That is, the ferroelectric capacitors FC1, FC2 polarize in reverse directions and shift in states to a point D and a point B on the hysteresis curve in Fig. 1. This ends the write operation.

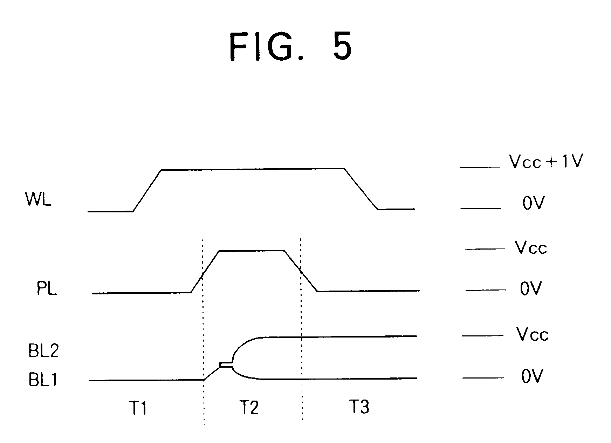

Next, an explanation will be made of the read operation referring to Fig. 5 to Fig. 7.

First, as shown in Fig. 5 and Fig. 6, 0V is applied to the bit lines BL1, BL2, after which they are made to open. At this time too, Vcc + 1V is applied to the word line WL.

Next, in the time T2, the potential of the plate line PL is raised from 0V to the power supply voltage Vcc.

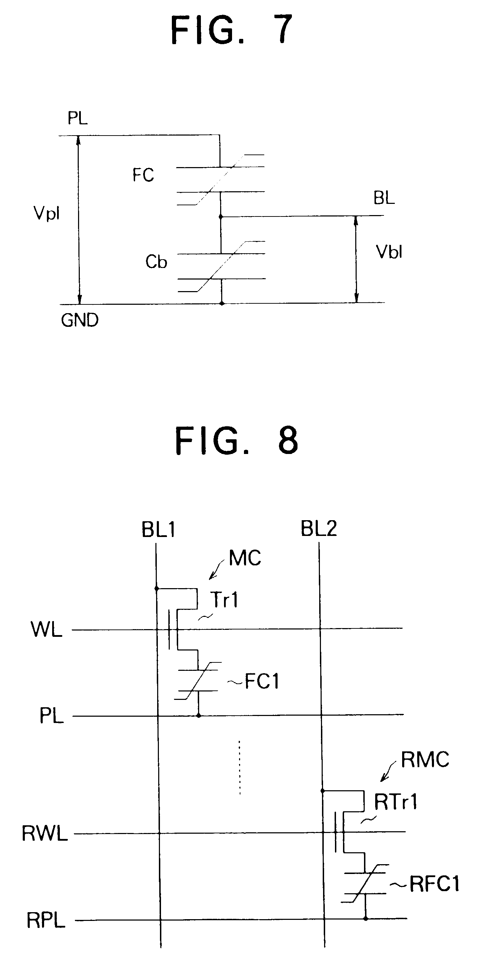

As shown in Fig. 7, when viewing the constitution of the memory cell from the plate lines, it may be represented by an equivalent circuit of a ferroelectric capacitor FC and a parasitic capacitance Cb of a bit line BL connected in series. When the potential of the plate line is raised from the ground level 0V to the power supply voltage Vcc, the potential output to the bit line differs according to the state of polarization of the ferroelectric.

That is, the state of polarization of the ferroelectric capacitor FC2 shifts from the point B to the point C on the hysteresis curve in Fig. 1 to reverse. On the other hand, the state of polarization of the ferroelectric capacitor FC1 shifts from the point D to the point C, and does not reverse. Accordingly, the ferroelectric capacitor FC2 which reverses in polarization shifts further in charge along with the change of polarization than the ferroelectric capacitor FC1 which does not reverse in polarization, and the potential of the bit line BL2 increases in comparison with the potential of the bit line BL1.

The difference between the potentials of the bit line BL1 and BL2 is detected and latched as Vcc or 0V according to the level of the potential by a not illustrated sense amplifier so as to perform the read operation.

At the time T3, finally, 0V is applied to the plate line PL again, so as to return the ferroelectric capacitor FC2 which reversed in polarization to its original state of polarization. This ends the read operation.

As mentioned above, the read operation of a 2Tr-2Cap type nonvolatile memory is constituted by two cycles, that is, a data latch operation increasing the potential of the plate line PL and a data re-write operation decreasing the potential of the plate line PL.

Figure 8 is a view of the basic one-bit constitution of a 1Tr - 1Cap type ferroelectric nonvolatile memory.

As shown in Fig. 8, in the memory cell, one bit is constituted by a switching transistor Tr1 comprised of an NMOS transistor with a drain electrode connected to a bit line BL1 and a ferroelectric capacitor FC1 with an electrode connected to a source electrode of the switching transistor Tr1. The gate electrode of the switching transistor Tr1 is connected to a word line WL, and the other electrode (plate electrode) of the ferroelectric capacitor FC1 is connected to a plate line PL.

A 1Tr - 1Cap type nonvolatile memory is further provided with a reference cell RMC comprised of a switching transistor RTr1 for reference with a drain electrode connected to a bit line BL2 for reference and a ferroelectric capacitor RFC1 for reference with an electrode connected to a source electrode of the switching transistor RTr1. The gate electrode of the switching transistor RTr1 is connected to the word line RWL for reference, and the other electrode of the ferroelectric capacitor RFC1 is connected to a plate line RPL for reference.

The ferroelectric capacitor RFC1 of the reference cell RMC is used as a usual dielectric without making the ferroelectric undergo a reversal in direction of polarization. The area of the capacitor is set so that the change of potential of the bit line when Vcc is applied to the plate line PRL for reference falls between the changes of potential of the bit line when the memory cell MC reverses in polarization and does not reverse in polarization, respectively.

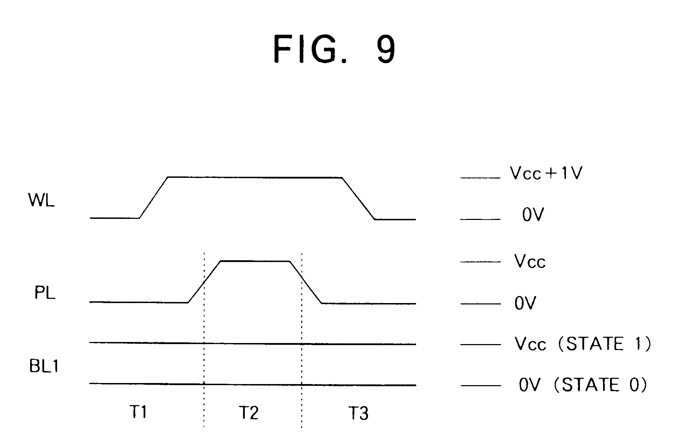

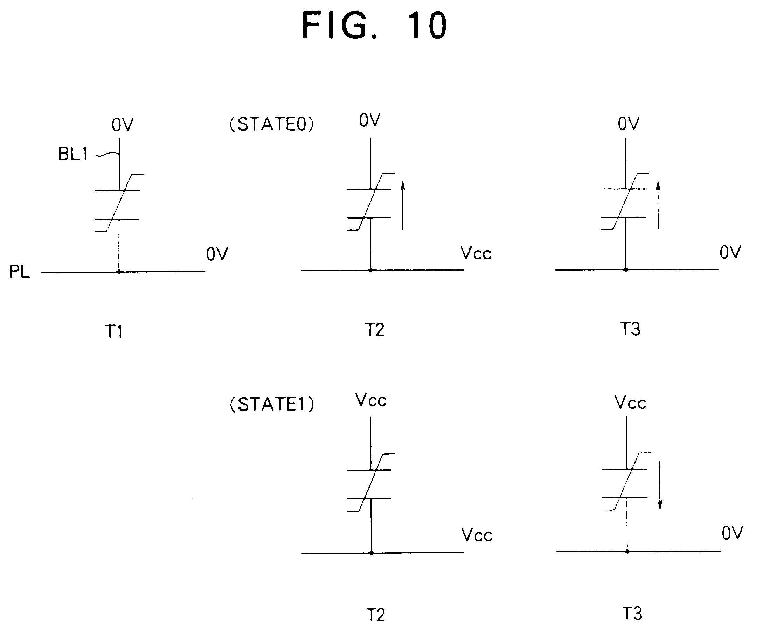

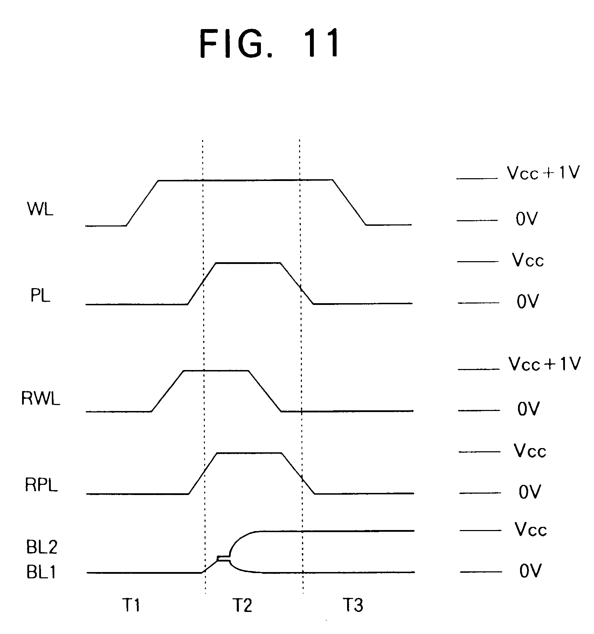

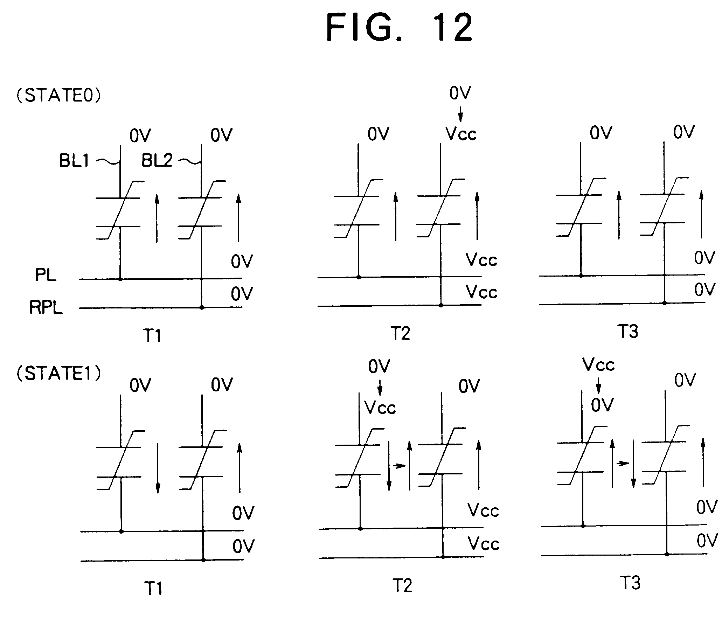

Next, an explanation will be made of the write and read operations of the 1Tr - 1Cap type nonvolatile memory, referring to Fig. 9 to Fig. 12. Figure 9 and Fig. 10 show a timing of the write operation and the corresponding state of polarization, respectively, while Fig. 11 and Fig. 12 show the timing of the read operation and the corresponding state of polarization, respectively.

The write and read operations of a 1Tr - 1Cap type memory are basically the same as in the above-mentioned 2Tr - 2Cap type.

The difference of the 1Tr - 1Cap type from the 2Tr - 2Cap type is that the potential difference between each of the bit lines connected to the usual memory cells and the bit line connected to the reference cell is detected.

In a data write operation, the voltages of the lines are controlled as shown in Fig. 9 and Fig. 10 to set the state of polarization of one ferroelectric capacitor to the point D of state 0 or the point B of state 1 on the hysteresis curve in Fig. 1 and thereby write one bit.

In a read operation, as shown in Fig. 11 and Fig. 12, the word line RWL and the plate line RPL for reference are driven in addition to the usual word line WL and plate line PL and, the difference between the potential of the bit line BL2 connected to the reference cell RMC and the potential of the bit line BL1 connected to the memory cell, which depends on the state of polarization, is detected.

Accordingly, since the reference cell RMC is used without making the ferroelectric undergo a reversal in direction of polarization, the potential of the reference word line RWL for reference is set to fall to 0V at a timing earlier than the timing of the fall of the plate line RPL for reference in order to prevent a re-write operation.

Note that, the read operation of the 1Tr - 1Cap type nonvolatile memory is constituted by two cycles, that is, an operation of detection of the potential of the plate line and an operation of re-writing data to the memory cell.

As obvious from above-mentioned explanation, in the data write and read operations of these types of memories, it is necessary to apply a high-speed pulse to a specific plate line PL connected to the selected memory cell and, in configuring the memory cell array, it is necessary to form a plate line PL having a low resistance in parallel with the word line WL.

In a dynamic random access memory (DRAM) wherein each bit is constituted by one transistor and one capacitor as in the above-mentioned 1Tr - 1Cap type ferroelectric memory, the potentials of all of the cells connected to a common plate line PL are usually fixed at the ground GND level or Vcc/2, so it is not necessary to divide the plate line for each word line, the plate electrodes become simple enough in pattern to be laid over the entire memory cell array, and it is not necessary to set the resistance at a lower value.

However, in a ferroelectric memory, since the word lines are divided, and due to the limits of patterning precision, it is impossible to decrease the area per memory cell. Also, it is necessary to increase the thickness of the electrodes to reduce the resistance. As a result, step differences are easily formed and it is difficult to form a high density memory. Accordingly, realization of a ferroelectric memory which can write and read data with a fixed potential of the plate electrodes the same as a DRAM has been desired.

Also, the above-mentioned read operation of the ferroelectric memory is constituted by two cycles, that is, comprised of an operation of detection of the change of the potential of the bit line and a re-write operation after that. That is, it is necessary to raise the plate line PL from 0V to the power supply voltage Vcc while the word line WL is selected and after that reduce it from the power supply voltage Vcc to 0V.

In usual DRAMs, the re-write operation is performed along with the data latch operation, so the above-mentioned ferroelectric memory needs double the time of a DRAM.

Accordingly, it is desirable to detect the change of the potential of the bit line and perform the re-write in the time of a single operation.

According to the ferroelectric memory of the present invention, for example, in the case of a 2Tr-2Cap type memory, in a write operation, the plate electrodes of the ferroelectric capacitors are fixed to a predetermined potential, the switching transistors are controlled to become conductive for a predetermined period, then a higher and a lower potential than the potentials of the plate electrodes are applied to the two bit lines to set the states of polarization of the ferroelectric capacitors.

Alternatively, in a write operation, for example, the switching transistors are controlled to become conductive for a predetermined period, a predetermined potential is applied to the plate electrodes of the ferroelectric capacitors, then a higher and a lower potential than the potential of the plate electrodes are applied to the two bit lines to set the states of polarization of the ferroelectric capacitors.

In a read operation, the potentials of the plate electrodes are fixed, and the switching transistors are controlled to become conductive for a predetermined period. The difference between the changes of potentials of the two bit lines when making the switching transistors conductive is detected, the two bit lines are latched to a higher and a lower potential than the potential of the plate electrodes by the difference, and data is re-written by the voltage applied to the electrodes of the ferroelectric capacitors. Disappearance of data is prevented by the re-write operation.

Alternatively, in a read operation, for example, the switching transistors are controlled to become conductive for a predetermined period, then a predetermined potential is applied to the plate electrodes of the ferroelectric capacitors. The difference between the changes of the potentials of the two bit lines when making the switching transistors conductive is detected, the two bit lines are latched to a higher and a lower potential than the potential of the plate electrodes by the difference, and data is re-written by the voltage applied to the electrodes of the ferroelectric capacitors.

According to the ferroelectric memory of the present invention, for example, in the case of a 1Tr-1Cap type memory, in a write operation, a plate electrode of the ferroelectric capacitor is fixed to a predetermined potential, the switching transistor is controlled to become conductive for a predetermined period, then a higher or a lower potential than the potential of the plate electrode is applied to the bit line to set the state of polarization of the ferroelectric capacitor.

Alternatively, in a write operation, for example, the switching transistor is controlled to become conductive for a predetermined period, a predetermined potential is applied to the plate electrode of the ferroelectric capacitor, then a higher or a lower potential than the potential of the plate electrode is applied to the bit line to set the state of polarization of the ferroelectric capacitor.

Also, in a read operation, the potential of the plate electrode is fixed and the switching transistor is control to become conductive for a predetermined period. The difference between the potential of the bit line when making the switching transistor conductive and a separately set reference potential is detected, the bit line is latched to a higher or a lower potential than the potential of the plate electrode by the difference, and data is re-written by the voltage applied to the electrodes of the ferroelectric capacitor.

Alternatively, in a read operation, for example, the switching transistor is controlled to become conductive state for a predetermined period, then a predetermined potential is applied to the plate electrode of the ferroelectric capacitor. The difference between the potential of the bit line when making the switching transistor conductive and a separately set reference potential is detected, the bit line is latched to a higher or a lower potential than the potential of the plate electrode by the difference, and data is re-written by the voltage applied to the electrodes of the ferroelectric capacitor.

A preferred embodiment of the present invention will be explained in detail next.

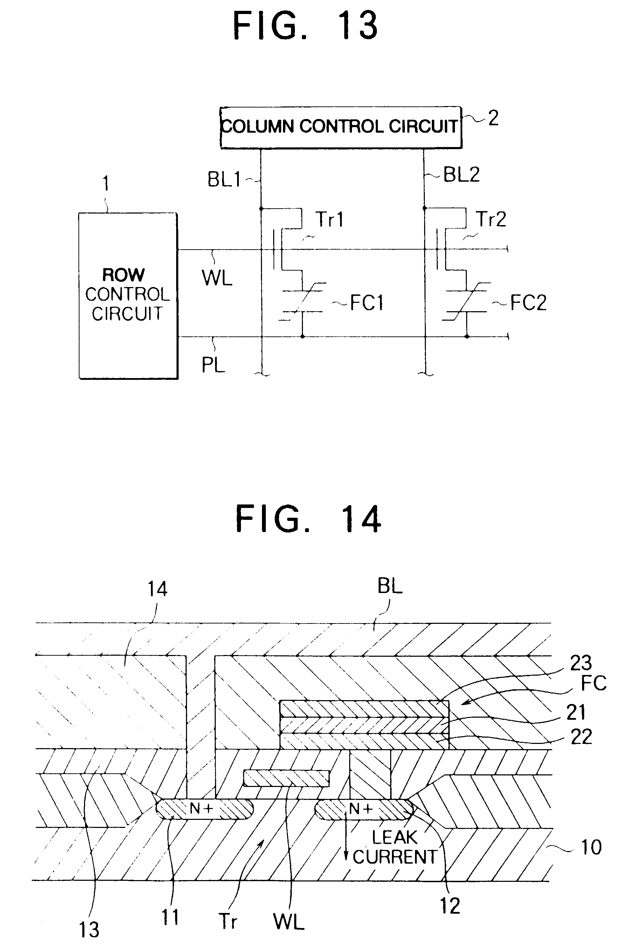

Figure 13 is a view of a basic one-bit constitution of a 2Tr - 2Cap type ferroelectric nonvolatile memory according to a first preferred embodiment of the present invention. Similar parts as in Fig. 2 are represented by same symbols in Fig. 13.

That is, Tr1, Tr2 represent switching transistors comprised of NMOS transistors, FC1, FC2 represent ferroelectric capacitors, BL1, BL2 represent bit lines, WL represents a word line, PL represents a plate line, 1 represents a row control circuit, and 2 represents a column control circuit.

As shown in Fig. 13, in a memory cell, drain electrodes of the switching transistors Tr1, Tr2 are connected to the bit lines BL1, BL2 respectively, source electrodes of the switching transistors Tr1, Tr2 are connected to one of the electrodes of the ferroelectric capacitors FC1, FC2, respectively, other electrodes (plate electrodes) of the ferroelectric capacitors FC1, FC2 are connected to a common plate line PL, and gate electrodes of the switching transistors Tr1, Tr2 are connected to a common word line WL.

The word line WL and the plate line PL are connected to the row control circuit 1, and the bit lines BL1, BL2 are connected to the column control circuit 2.

The row control circuit 1 applies a predetermined voltage Vcc/2 to the plate line to fix the potentials of the plate electrodes of the ferroelectric capacitors FC1, FC2 at a predetermined potential and applies a voltage Vcc + 1V to the word line WL for a predetermined period T2 to make the switching transistors Tr1, Tr2 conductive when receiving a write command or a read command.

At the time of a write command, the column control circuit 2 applies to the two bit lines BL1, BL2 respective potentials higher and lower than the Vcc/2 of the plate line PL (namely higher and lower than the potentials of the plate electrodes of the ferroelectric capacitors FC1, FC2), for example, 0V and the power supply voltage Vcc.

At the time of a read command, the column control circuit 2 detects the difference between the changes of the potentials of two bit lines BL1, BL2 when the switching transistors Tr1, Tr2 are made conductive, latches the two bit lines BL1, BL2 to respective higher and lower potentials than the potential Vcc/2 of the plate electrodes according to the difference, and rewrites the data by the voltage applied to the electrodes of the ferroelectric capacitors FC1, FC2.

Further, to prevent data loss when operating the memory, the column control circuit 2 performs a refresh operation by applying to the bit lines BL at a predetermined cycle a voltage equal to the fixed voltage Vcc/2 applied to the plate electrodes.

Note that, in practice, the system for detection and latching difference of the potential between bit lines typically may be constituted by a differential type sense amplifier.

Figure 14 is a cross-sectional view of principal parts of a memory cell.

In Fig. 14, 10 represents a semiconductor substrate, 11 represents a drain diffusion layer of a switching transistor Tr, 12 represents a source diffusion layer, and 13, 14 represent interlayer insulation films. Also, 21 represents a ferroelectric film of a ferroelectric capacitor FC, 22 represents a bit line side electrode, and 23 represents a plate electrode.

In the memory cell, as shown in Fig. 14, the bit line BL is connected to the drain diffusion layer 11, and the bit line side electrode 22 of the ferroelectric capacitor FC is connected to the source diffusion layer 12.

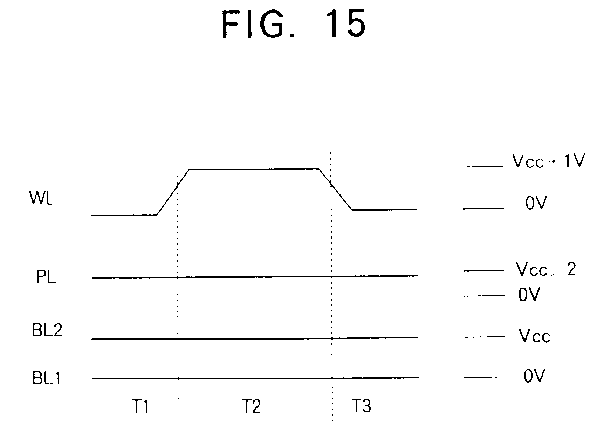

Next, an explanation will be made of the write and read operations of the 2Tr - 2Cap type nonvolatile memory of the first embodiment by referring to Fig. 15 to Fig. 18.

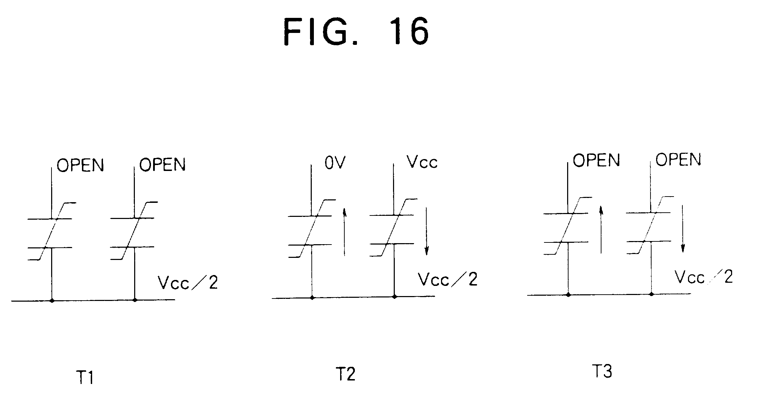

First, an explanation will be made of the write operation by referring to Fig. 15 and Fig. 16.

Figure 15 is a timing chart of potentials applied to the terminals in the write operation. Figure 16 shows the states of polarization of a ferroelectric capacitor at corresponding times.

In the write operation, first, at the time T1, a ground GND level 0V is applied to the bit line BL1 and a power supply voltage Vcc is applied to the bit line BL2 by the column control circuit 2, and Vcc/2 is applied to the plate line PL by the row control circuit 1. Note that the voltage applied to the plate line PL is fixed to Vcc/2 in the write operation periods T1 to T3.

Next, at the time T2, Vcc + 1V is applied to the word line WL by the row control circuit 1. Note that the reason for applying a voltage higher than Vcc by 1V is that the threshold voltage Vth of the switching transistor is less than 1V, so it is necessary to prevent a voltage drop due to the transistor.

Due to this, the switching transistors Tr1, Tr2 switch from a non-conductive state to a conductive state, the voltage 0V is applied to a bit line side electrode (one electrode) of the ferroelectric capacitor FC1, and the voltage Vcc is applied to a bit line side electrode of the ferroelectric capacitor FC2.

Due to this, the voltage Vcc/2 is applied to the two ferroelectric capacitors FC1, FC2 in reverse directions. As a result, at the ferroelectric capacitor FC1 side, the polarization is carried out in a direction from the plate electrode to the bit line side electrode, while at the ferroelectric capacitor FC2 side, the polarization is carried out in a direction from the bit line side electrode to the plate electrode. That is, the two ferroelectric capacitors FC1, FC2 reverse in polarization in reverse directions. The data is written by those directions.

At the time T3, the potential of the word line WL is switched from Vcc + 1V to 0V by the row control circuit 1. Due to this, the switching transistors Tr1, Tr2 switch from the conductive state to the non-conductive state. This ends the write operation.

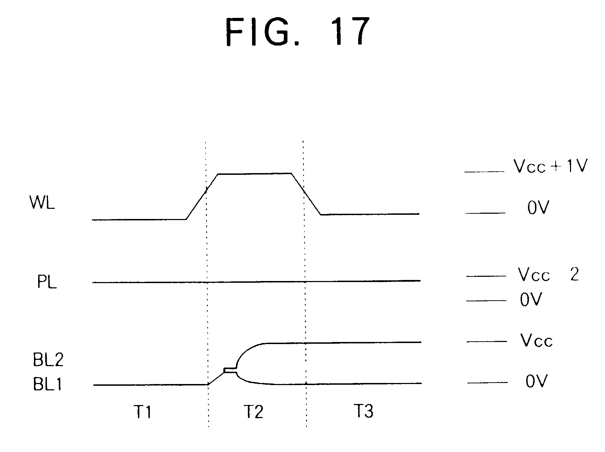

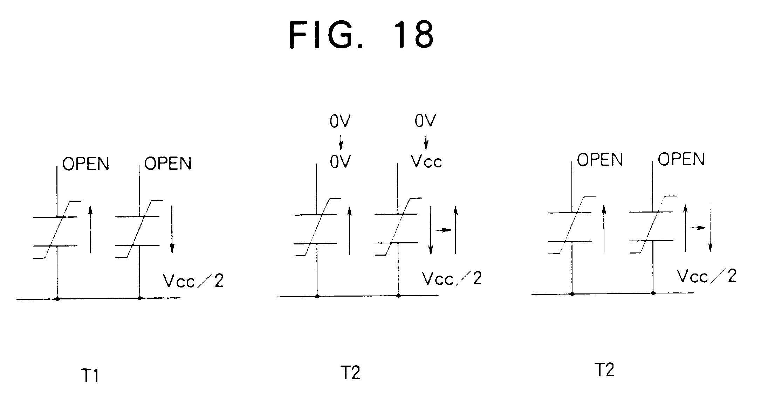

Next, an explanation will be made of the read operation by referring to Fig. 17 and Fig. 18.

First, at a time T1, 0V is applied to the bit lines BL1, BL2 by the column control circuit 2. After this, the bit lines BL1, BL2 are made open. At this time, Vcc/2 is applied to the plate line PL by the row control circuit 1. Note that the voltage applied to the plate line PL is fixed to Vcc/2 for the read operation periods T1 to T3.

Next, at the time T2, Vcc +1V is applied to the word line WL by the row control circuit 1. Due to this, the switching transistors Tr1, Tr2 switch from the non-conductive state to the conductive state, and the potentials of the bit lines BL1, BL2 change according to the states of polarization of the ferroelectric capacitors FC1, FC2.

The column control circuit 2, in actuality a sense amplifier connected to the bit lines BL1, BL2, latches the bit line BL1 connected to the ferroelectric capacitor FC1 which does not reverse in polarization to 0V and the bit line BL2 connected to the ferroelectric capacitor FC2 which reverses in polarization to Vcc so as to read the data.

At the same time, the voltage Vcc/2 is applied to the ferroelectric capacitors FC1, FC2 in the reverse direction so as to perform a re-write operation and return the capacitors to their original states.

Since the read operation is performed by applying Vcc/2 to the plate electrode in this way, the operation of detection of data and the operation of re-writing data in the read operation are performed at one time.

After this, the potential of the word line WL is switched from Vcc + 1V to 0V by the row control circuit 1. Due to this, the switching transistors Tr1, Tr2 switch from the conductive state to the non-conductive state. This ends the read operation.

Note that in the above-mentioned operation, when the power is on, it is sufficient to fix the potential of the plate line PL to Vcc/2, but, as shown in Fig. 14, usually the bit line side electrodes 22 of the ferroelectric capacitors FC1, FC2 are connected to the diffusion layers 12 of the switching transistors Tr, so the potentials of the bit line side electrodes fall along with time due to leakage current of the diffusion layers.

Accordingly, if the time wherein the switching transistors Trl, Tr2 are held in the non-conductive states is too long, the potentials of the bit line side electrodes 22 will switch to 0V (the potential of the substrate is 0V), Vcc/2 will be applied to the ferroelectric capacitors FC1, FC2 automatically, and the states of polarization will be disturbed.

Accordingly, in the memory cell of the present invention, when the power is on, Vcc/2 is applied to the bit lines BL1, BL2 by the column control circuit 2 every predetermined time and, the voltage Vcc + 1V is applied to the word line WL by the row control circuit 1 to make the switching transistors Tr1, Tr2 conductive and apply this Vcc/2 to the bit lines side electrodes of the ferroelectric capacitors Fc1, FC2. Due to this, the difference of potential applied to the two terminals of the capacitors becomes small and an erroneous reversal of polarization is prevented.

The cycle time of applying voltage is set to about 20 msec in, for example, a 4 Mega bit memory.

Note that the problem of the potential of the capacitors changing due to the leakage current of the diffusion layers also occurs in a DRAM. In a DRAM, the loss of data is prevented by a refresh function whereby a re-write operation is performed every predetermined time. This operation is performed by applying a potential to the bit lines every predetermined cycle.

Note that, while the above-mentioned embodiment was explained with reference to the example wherein the voltage applied to the plate line PL at the time of write and read operations is fixed to Vcc/2 for the times T1 to T3, it is possible to perform the write and read operations by applying Vcc/2 to the plate line PL for only a predetermined time T2 while the switching transistors Tr1, Tr2 are made conductive by applying the voltage Vcc + 1V to the word line WL.

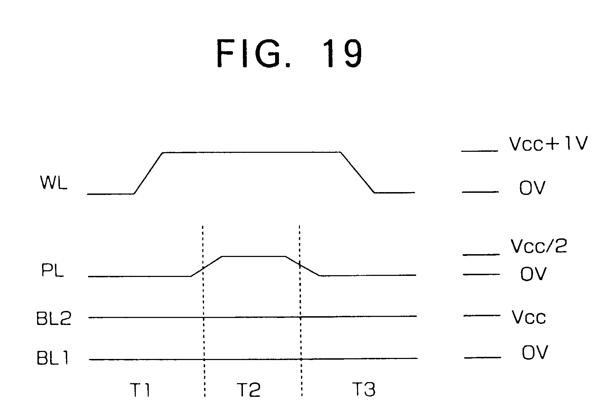

Figures 19 to 22 show timing charts of write and read operations performed by applying Vcc/2 to the plate line PL for exactly a predetermined time and the states of polarization of the ferroelectric capacitors at these times.

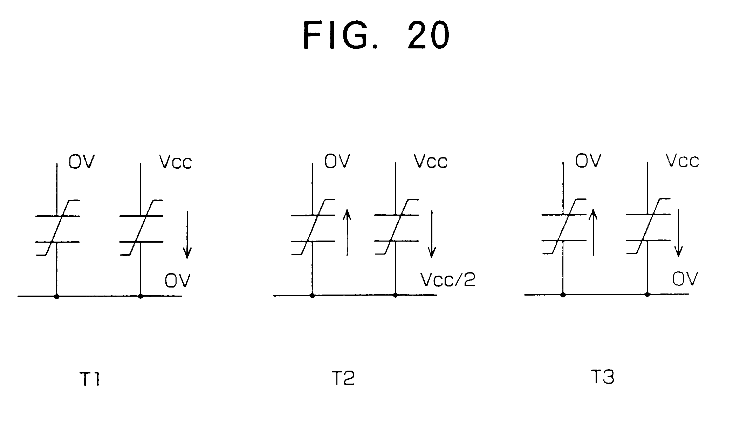

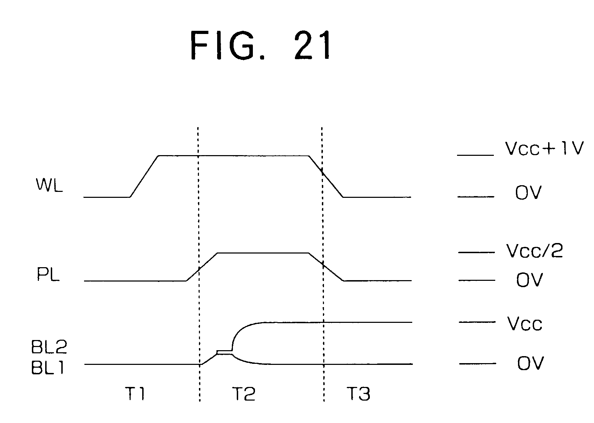

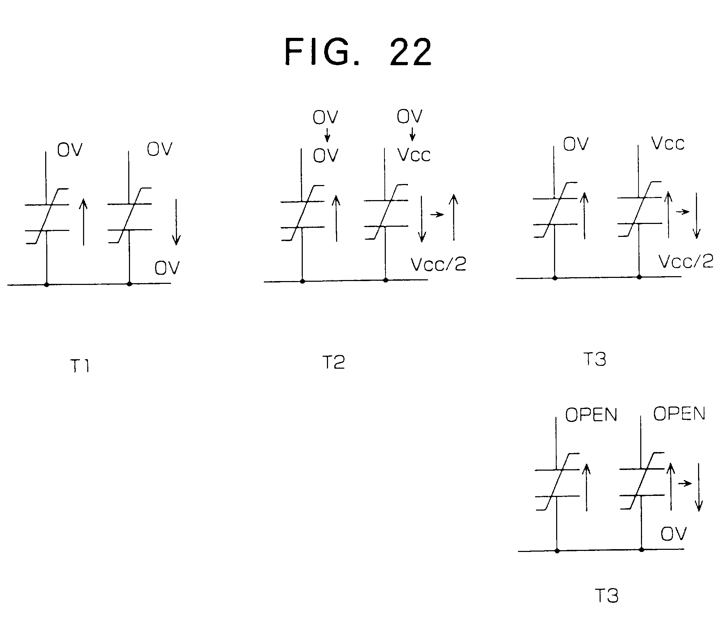

That is, Fig. 19 is a timing chart of potentials applied to the various lines in the write operation, Fig. 20 shows the states of polarization of a ferroelectric capacitor in the write operation corresponding to Fig. 19, Fig. 21 is a timing chart of potentials of the lines in the read operation, and Fig. 22 shows the states of polarization of a ferroelectric capacitor in the read operation corresponding to Fig. 21.

The write and read operations are preferably the same as those mentioned above. However, in this case, since Vcc/2 is applied to the plate line PL for exactly a predetermined period, the problem of the potential of the capacitor changing due to a leakage current of the diffusion layer does not arise. Accordingly, a refresh operation is not necessary.

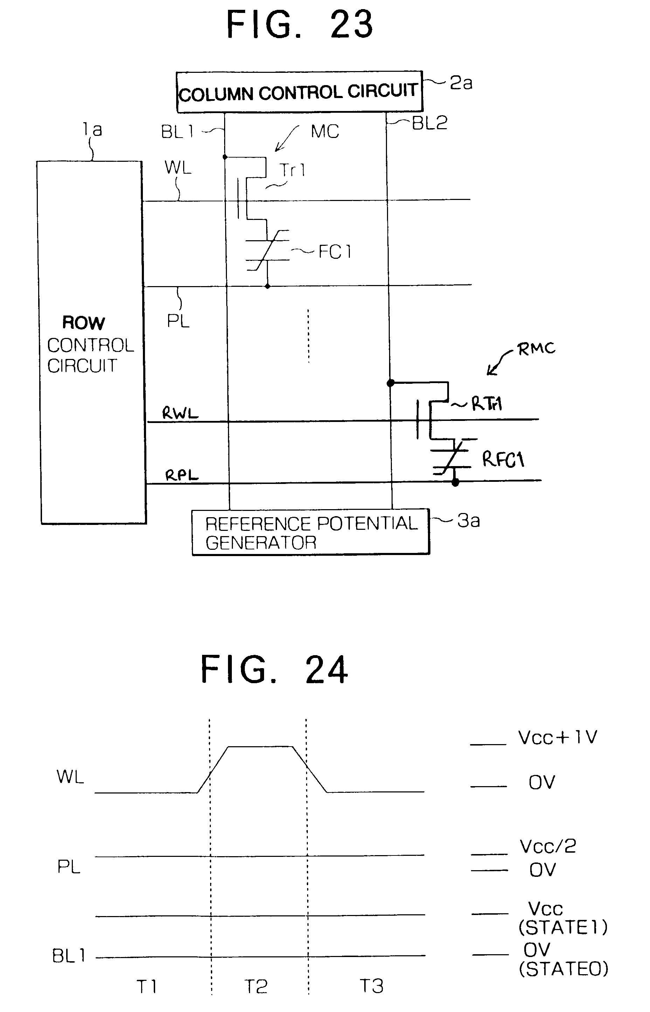

Figure 23 is a view of a basic one-bit constitution of a 1Tr - 1Cap type ferroelectric nonvolatile memory according to another preferred embodiment of the present invention. Similar parts as in Fig. 8 are represented by the same symbols in Fig. 23.

That is, MC represents a usual memory cell, Tr1 represents a switching transistor, FC1 represents a ferroelectric capacitor, RMC represents a reference cell, RTr1 represents a switching transistor for reference, RFC1 represents a ferroelectric capacitor for reference, BL1, BL2 represent bit lines, WL represents a word line, PL represents a plate line, RWL represents a word line for reference, RPL represents a plate line for reference, 1a represents a row control circuit, 2a represents a column control circuit, and 3a represents a reference potential generator.

In the memory cell MC, the drain electrode of the switching transistor Tr1 is connected to the bit line BL1, the source electrode of the switching transistor Tr1 is connected to one electrode of the ferroelectric capacitor FC1, the other electrode (plate electrode) of the ferroelectric capacitor FC1 is connected to a plate line PL, and the gate electrode of the switching transistor Tr1 is connected to a word line WL.

In the reference cell RMC, the drain electrode of the switching transistor RTr1 is connected to the bit line BL2, the source electrode of the switching transistor RTr1 is connected to one electrode of the ferroelectric capacitor RFC1, the other electrode (plate electrode) of the ferroelectric capacitor RFC1 is connected to the plate line RPL for reference, and the gate electrode of the switching transistor RTr1 is connected to the word line RWL for reference.

The word line WL, the plate line PL, the word line RWL for reference, and the plate line RPL for reference are connected to the row control circuit la, while the bit lines BL1, BL2 are connected to the column control circuit 2a.

In the case of a 1Tr - 1Cap type memory, the write and the read operations are basically the same as in the above-mentioned 2Tr - 2Cap type memory under the control of the row control circuit la and the column control circuit 2a. Thus, a detailed explanation is omitted.

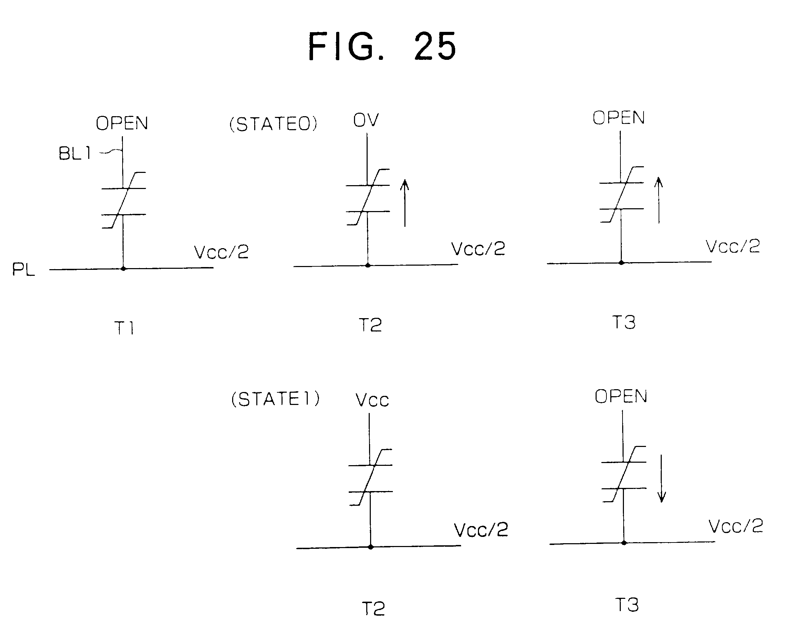

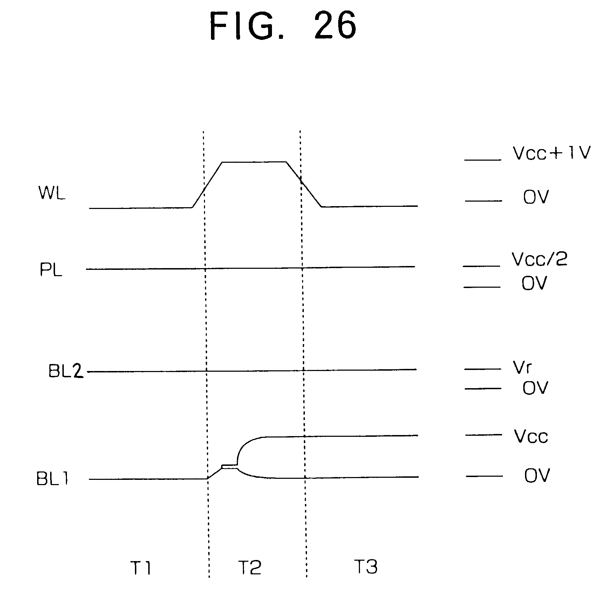

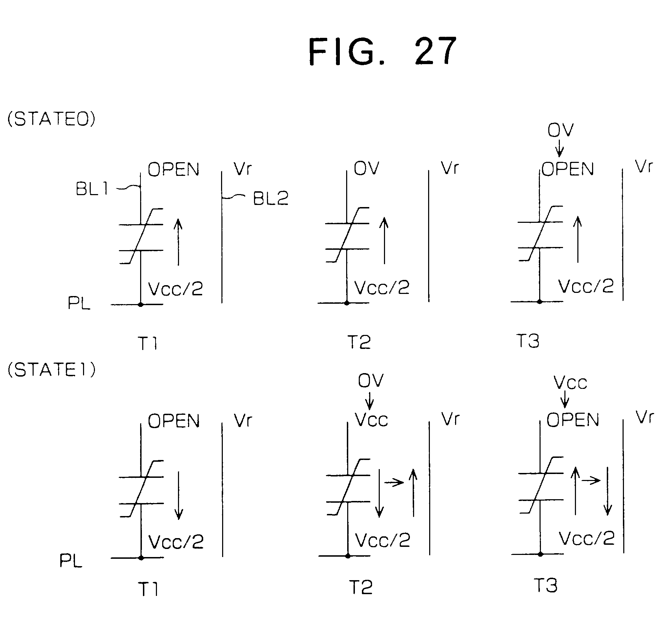

Figure 24 is a timing chart of potentials applied to the lines in the write operation, Fig. 25 shows the states of polarization of a ferroelectric capacitor in the write operation corresponding to Fig. 24, Fig. 26 is a timing chart of potentials of the lines in the read operation, and Fig. 27 shows the states of polarization of a ferroelectric capacitor in the read operation corresponding to Fig. 26.

Note that, in the case of the 1Tr - 1Cap type memory according to the present invention, as shown in Fig. 11 and Fig. 12, when a ferroelectric capacitor is used for generating a reference potential as same as the usual 1Tr - 1Cap type memory shown in Fig. 8, a reversal of polarization of the reference capacitor occurs by the re-write operation the same as in the operation of the 2Tr - 2Cap type memory.

Accordingly, in the case of the 1Tr - 1Cap type memory, as shown in Fig. 23, a reference potential is not generated by the capacitor. A fixed voltage Vr between the change of potential of the bit line at the state 0 and state 1 is generated by the reference potential generator 3a by division of the power supply voltage by resistors etc. The difference between the potential of the bit line BL2 supplying that potential and the potential of the bit line BL1 connected to the memory cell MC in the read operation is detected.

Alternatively, the lTr - 1Cap type memory can be constituted so that, instead of the voltage applied to the plate line PL being fixed to Vcc/2 for the times T1 to T3 in the write and read operations, Vcc/2 is applied to the plate line PL for exactly a predetermined time when the switching transistor Tr1 is made conductive by applying the voltage Vcc + 1V to the word line WL.

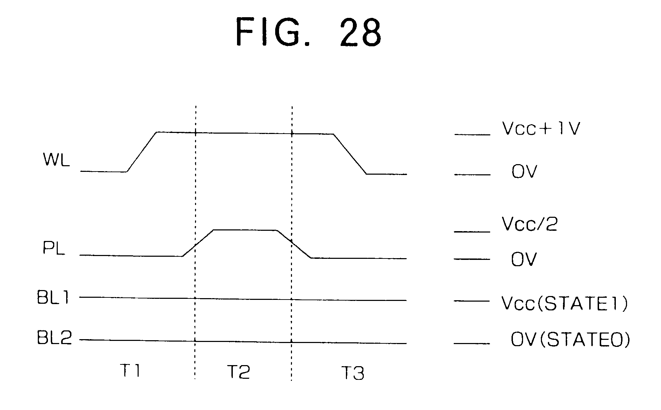

Figures 28 to 31 show timing charts of the write and read operations performed by applying Vcc/2 to the plate line PL for exactly a predetermined time and the states of polarization of the ferroelectric capacitor at corresponding times.

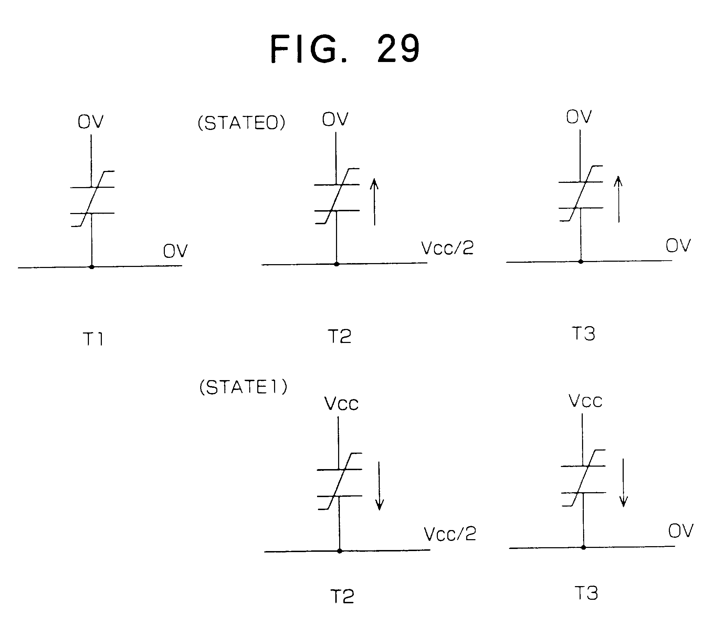

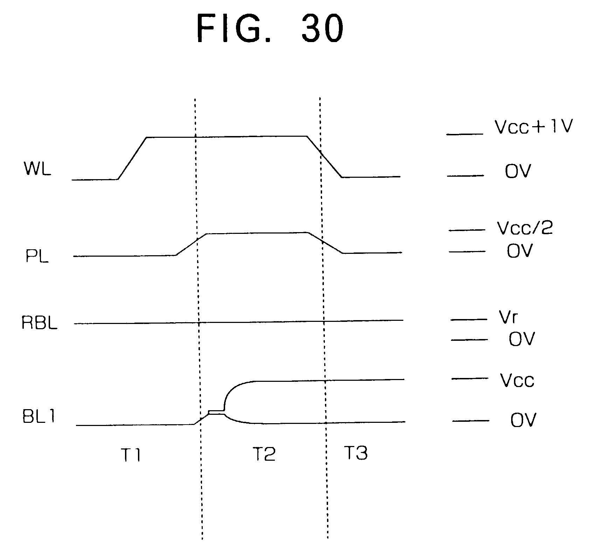

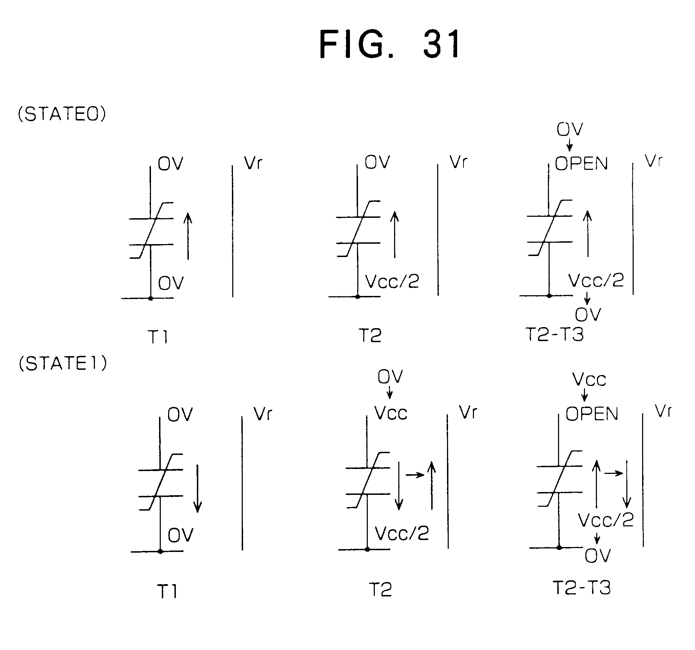

That is, Fig. 28 is a timing chart of potentials applied to the various lines in a write operation, Fig. 29 shows the states of polarization of a ferroelectric capacitor in the write operation corresponding to Fig. 28, Fig. 30 is a timing chart of potentials of the lines in a read operation, and Fig. 31 shows the states of polarization of a ferroelectric capacitor in the read operation corresponding to Fig. 30.

As explained above, according to the first embodiment, the write and read operations can be performed by fixing the plate electrode to a predetermined voltage. Accordingly, the plate line does not have to be divided for every word line, the plate electrodes become simple enough in pattern to be laid over the entire memory cell array, and it is not necessary to set the resistance to a lower value in view of speed, so the structure of the memory cell is simplified and it is possible to realize a cell design suitably for higher density integration.

Also, according to the first and second embodiments, since the read operation is performed by applying Vcc/2 to the plate line, the data detection and re-write of the read operation can be performed in one cycle, so it is possible to increase the speed of the read operation.

Note that while the preferred embodiments were explained with reference to the fixed potential of the plate electrode being Vcc/2, according to the invention this may be set to other fixed voltages, and operated in the same way as mentioned above.

Many widely different embodiments of the present invention may be constructed without departing from the scope of the invention. It is understood that the present invention is not restricted to the specific embodiments described above.

## Claims

1. A ferroelectric memory comprising:
first (BL1) and second (BL2) bit lines;
a memory cell comprising a first ferroelectric capacitor (FC1) having first and second electrodes, a first switching transistor (Tr1) connected between the first bit line (BL1) and the first electrode of the first ferroelectric capacitor (FC1), a second ferroelectric capacitor (FC2) having first and second electrodes, and a second switching transistor (Tr2) connected between the second bit line (BL2) and the first electrode of the second ferroelectric capacitor (FC2);
a first means (1) for making the potentials of the second electrodes of the first and second ferroelectric capacitors a predetermined fixed potential and then making the first and second switching transistors conductive in a data write operation; and
a second means (2) for applying a higher potential and a lower potential than a potential of the second electrodes of the first and second ferroelectric capacitors to the first and second bit lines complementarily.

2. A ferroelectric memory according to claim 1, wherein
the potential of the second electrodes of the first and second ferroelectric capacitors is between the higher potential and the lower potential applied to the first and second bit lines.

3. A ferroelectric memory according to claim 1, wherein
the second electrodes of the first and second ferroelectric capacitors are connected to a common plate line (PL);
gate electrodes of the first and second switching transistors are connected to a common word line (WL); and
the first means (1) applies the predetermined fixed potential to the plate line (PL) and applies a predetermined potential to the word line (WL) in order to make the first and second switching transistors conductive in a data write operation.

4. A ferroelectric memory, comprising:
first (BL1) and second (BL2) bit lines;
a memory cell comprising a first ferroelectric capacitor (FC1) having first and second electrodes, a first switching transistor (Tr1) connected between the first bit line (BL1) and the first electrode of the first ferroelectric capacitor (FC1), a second ferroelectric capacitor (FC2) having first and second electrodes, and a second switching transistor (Tr2) connected between the second bit line (BL2) and the first electrode of the second ferroelectric capacitor (FC2);
a first means (1) for making the first and second switching transistors conductive and then making the potentials of the second electrodes of the first and second ferroelectric capacitors a predetermined fixed potential in a data write operation; and
a second means (2) for applying a higher potential and a lower potential than a potential of the second electrodes of the first and second ferroelectric capacitors to the first and second bit lines complementarily.

5. A ferroelectric memory according to claim 4, wherein
the potential of the second electrodes of the first and second ferroelectric capacitors is between the higher potential and the lower potential applied to the first and second bit lines.

6. A ferroelectric memory according to claim 4, wherein
the second electrodes of the first and second ferroelectric capacitors are connected to a common plate line (PL);
gate electrodes of the first and second switching transistors are connected to a common word line (WL); and
the first means (1) applies a predetermined potential to the word line (WL) in order to make the first and second switching transistors conductive and applies the predetermined fixed potential to the plate line (PL) in a data write operation.

7. A ferroelectric memory, comprising:
first (BL1) and second (BL2) bit lines;
a memory cell comprising a first ferroelectric capacitor (FC1) having first and second electrodes, a first switching transistor (Tr1) connected between the first bit line (BL1) and the first electrode of the first ferroelectric capacitor (FC1), a second ferroelectric capacitor (FC2) having first and second electrodes, and a second switching transistor (Tr2) connected between the second bit line (BL2) and the first electrode of the second ferroelectric capacitor (FC1);
a first means (1) for making the potentials of the second electrodes of the first and second ferroelectric capacitors a predetermined fixed potential and then making the first and second switching transistors conductive in a data read operation; and
a second means (2) for detecting a difference between a potential of the first bit line and a potential of the second bit line when the switching transistors are made conductive, latching the first and second bit lines by the difference, and making the first and second ferroelectric capacitors perform re-write operations by the potentials applied to the first and second electrodes of the first and second ferroelectric capacitors.

8. A ferroelectric memory according to claim 7, wherein
the potential of the second electrodes of the first and second ferroelectric capacitors is between the higher potential and the lower potential applied to the first and second bit lines.

9. A ferroelectric memory according to claim 7, wherein
the second electrodes of the first and second ferroelectric capacitors are connected to a common plate line (PL);
gate electrodes of the first and second switching transistors are connected to a common word line (WL); and
the first means (1) applies the predetermined fixed potential to the plate line (PL) and applies a predetermined potential to the word line (WL) in order to make the first and second switching transistors conduction in a data read operation.

10. A ferroelectric memory, comprising:
first (BL1) and second (BL2) bit lines;
a memory cell comprising a first ferroelectric capacitor (FC1) having first and second electrodes, a first switching transistor (Tr1) connected between the first bit line (BL1) and the first electrode of the first ferroelectric capacitor (FC1), a second ferroelectric capacitor (FC2) having first and second electrodes, and a second switching transistor (Tr2) connected between the second bit line (BL2) and the first electrode of the second ferroelectric capacitor (FC2);
a first means (1) for making the first and second switching transistors conductive and then making the potentials of the second electrodes of the first and second ferroelectric capacitors a predetermined fixed potential in a data read operation; and
a second means (2) for applying a difference between a potential of the first bit line and a potential of the second bit line when the predetermined fixed potential is applied to the second electrodes of the first and second ferroelectric capacitors, latching the first and second bit lines by the difference, and making the first and second ferroelectric capacitors perform re-write operations by the potentials applied to the first nd second electrodes of the first and second ferroelectric capacitors.

11. A ferroelectric memory according to claim 10, wherein
the potential of the second electodes of the first and second ferroelectric capacitors is between the higher potential and the lower potential applied to the first and second bit lines.

12. A ferroelectric memory according to claim 10, wherein
the second electrodes of the first and second ferroelectric capacitors are connected to a common plate line (PL);
gate electrodes of the first and second switching transistors are connected to a common word line (WL); and
the first means (1) applies a predetermined potential to the word line (WL) in order to make the first and second switching transistors conductive and applies the predetermined fixed potential to the plate line (PL) in a data read operation.

13. A ferroelectric memory, comprising:
first (BL1) and second (BL2) bit lines;
a memory cell (MC) comprising a ferroelectric capacitor (FC1) having first and second electrodes and a switching transistor (Tr1) connected between the first bit line (BL1) and the first electrode of the ferroelectric capacitor (FC1);
a first means (1a) for making the potential of the second electrode of the ferroelectric capacitor (FC1) a predetermined fixed potential and then making the switching transistor (Tr1) conductive in a data write operation; and
a second means (2a) for applying a higher potential and a lower potential than a potential of the second electrode of the ferroelectric capacitor (FC1) to the first and second bit lines (BL1, BL2) complementarily.

14. A ferroelectric memory according to claim 13, wherein
the potential of the second electrode of the ferroelectric capacitor (FC1) is between the higher potential and the lower potential applied to the first and second bit lines (BL1, BL2).

15. A ferroelectric memory according to claim 13, wherein
the second electrode of the ferroelectric capacitor (FC1) is connected to a plate line (PL);
a gate electrode of the switching transistor (Tr1) is connected to a word line (WL); and
the first means (1a) applies the predetermined fixed potential to the plate line (PL) and applies a predetermined potential to the word line (WL) in order to make the switching transistor (Tr1) conductive in a data write operation.

16. A ferroelectric memory, comprising:
first (BL1) and second (BL2) bit lines;
a memory cell (MC) comprising a ferroelectric capacitor (FC1) having first and second electrode and a switching transistor (Tr1) connected between the first bit line and the first electrode of the ferroelectric capacitor;
a first means (1a) for making the switching transistor conductive and then making the potential of the second electrode of the ferroelectric capacitor a predetermined fixed potential in a data write operation; and
a second means (2a) for applying a higher potential and a lower potential than a potential of the second electrode of the ferroelectric capacitor to the first and second bit lines complementarily.

17. A ferroelectric memory according to claim 16, wherein
the potential of the second electrode of the ferroelectric capacitor (FC1) is between the higher potential and the lower potential applied to the first and second bit lines (BL1, BL2).

18. A ferroelectric memory according to claim 16, wherein
the second electrode of the ferroelectric capacitor is connected to a plate line (PL);
a gate electrode of the switching transistor is connected to a word line (WL); and
the first means (1a) applies a predetermined potential to the word line in order to make the switching transistor conductive and applies the predetermined fixed potential to the plate line in a data write operation.

19. A ferroelectric memory, comprising:
first (BL1) and second (BL2) bit lines;
a memory cell (MC) comprising a ferroelectric capacitor (FC1) having first and second electrodes and a switching transistor (Tr1) connected between the first bit line and the first electrode of the ferroelectric capacitor;
a first means (1a) for making the potential of the second electrode of the ferroelectric capacitor a predetermined fixed potential and then making the switching transistor conductive in a data read operation; and
a second means (2a) for detecting a difference between a potential of the bit line and a separately set reference potential when the switching transistor is made conductive, latching the first and second bit lines by the difference, and making the ferroelectric capacitor perform a re-write operation by the potential applied to the first and second electrodes of the ferroelectric capacitor.

20. A ferroelectric memory according to claim 19, wherein
the potential of the second electrode of the ferroelectric capacitor is between the higher potential and the lower potential applied to the first and second bit lines.

21. A ferroelectric memory according to claim 19, wherein
the second electrode of the ferroelectric capacitor is connected to a plate line (PL);
a gate electrode of the switching transistor is connected to a word line (WL); and
the first means (1a) applies the predetermined fixed potential to the plate line (PL) and applies a predetermined potential to the word line (WL) in order to make the switching transistor conductive in a data read operation.

22. A ferroelectric memory, comprising:
first (BL1) and second (BL2) bit lines;
a memory cell (MC) comprising a ferroelectric capacitor (FC1) having first and second electrodes and a switching transistor (Tr1) connected between the first bit line and the first electrode of the ferroelectric capacitor;
a first means (1a) for making the switching transistor conductive and then making the potential of the second electrode of the ferroelectric capacitor a predetermined fixed potential in a data read operation; and
a second means (2a) for detecting a difference between a potential of the bit line and a separately set reference potential when the predetermined fixed potential is applied to the second electrode of the ferroelectric capacitor, latching the first and second bit lines by the difference, and making the ferroelectric capacitor perform a re-write operation by the potential applied to the first and second electrodes of the ferroelectric capacitor.

23. A ferroelectric memory according to claim 22, wherein
the potential of the second electrode of the ferroelectric capacitor is between the higher potential and the lower potential applied to the first and second bit lines.

24. A ferroelectric memory according to claim 22, wherein
the second electrode of the ferroelectric capacitor is connected to a plate line (PL);
a gate electrode of the switching transistor is connected to a word line (WL); and
the first means (1a) applies a predetermined potential to the word line (WL) in order to make the switching transistor conductive and applies the predetermined fixed potential to the plate line (PL) in a data read operation.
